# EUROPÄISCHE PATENTSCHRIFT

(11) **EP 1 349 281 B1**
(45) Veröffentlichungstag und Bekanntmachung des Hinweises auf die Patenterteilung: **29.07.2009**
(21) Anmeldenummer: 03005583.4
(22) Anmeldetag: 12.03.2003
(51) Int. Cl.: H03K 17/97

(54) **Bedienvorrichtung für ein Elektrogerät**
Control apparatus for an electric appliance
Dispositif de commande pour un appareil électrique

(30) Priorität: 19.03.2002 DE 10212954
(43) Veröffentlichungstag der Anmeldung: 01.10.2003
(73) Patentinhaber: E.G.O. ELEKTRO-GERÄTEBAU GmbH, D-75038 Oberderdingen (DE)
(72) Erfinder: Schilling, Wilfried, 76703 Kraichtal (DE)
(74) Vertreter: Patentanwälte Ruff, Wilhelm, Beier, Dauster & Partner

(56) Entgegenhaltungen:
- EP-A- 0 565 976
- US-A- 5 920 131

## Beschreibung

Die Erfindung betrifft eine Bedienvorrichtung für ein Elektrogerät, vorzugsweise ein Elektrowärmegerät wie ein Kochfeld.

Aus der EP 600 780 A1 ist beispielsweise eine Bedienvorrichtung für einen Elektroherd bekannt. Hier wird eine Drehvorrichtung nach Art eines Drehknebels in eine Halterung an der Oberfläche einer Bedieneinheit eingesetzt. In dem Drehknebel sind Magnete vorgesehen, welche auf Reed-Schalter unterhalb der Oberfläche wirken. Dadurch kann eine Drehung des Drehknebels festgestellt werden und davon abhängig ein Schaltsignal erzeugt werden. Hierbei besteht der Nachteil, dass die Zuordnung der signalerzeugenden Signalmittel zu dem Drehknebel nicht immer ganz einfach ist. Bei fehlerhafter Zuordnung treten Störungen auf.

Die EP 565 976 A1 beschreibt eine Bedieneinheit für ein Haushaltsgerät. Diese Bedieneinheit kann als externe Funktionseinheit an ein Elektrogerät angesetzt werden in einer ganz bestimmten Position. Die Bedieneinheit weist Anzeigen sowie Druckknöpfe in der Art von Folientastern auf. Des Weiteren ist eine induktive Energieübertragung für die Bedieneinheit vorgesehen sowie eine Signalübertragung, bspw. als IR-Signalübertragung.

### Aufgabe und Lösung

Der Erfindung liegt die Aufgabe zugrunde, eine eingangs genannte Bedienvorrichtung zu schaffen, mit der die Nachteile des Standes der Technik vermieden werden können, insbesondere hinsichtlich des Aufwandes für das gesamte Elektrogerät sowie hinsichtlich des Bedienungskomforts und der Bedienungssicherheit.

Gelöst wird diese Aufgabe durch eine Bedienvorrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß weist eine Bedienvorrichtung eine Bedieneinheit auf, welche wiederum eine Drehvorrichtung zur Drehbedienung des Elektrogeräts aufweist. Die Bedieneinheit ist dabei auf einer Abdeckung oder Oberfläche des Elektrogeräts befestigbar. Ausschließlich in der Bedieneinheit sind Signalmittel vorgesehen, die abhängig von einer Stellung und/oder Stellungsänderung der Drehvorrichtung Signale erzeugen. Diese Signale können von einer Steuerung der Bedieneinheit verarbeitet werden, um das Elektrogerät entsprechend der Bedienung zu beeinflussen. Das Elektrogerät ist dabei mit den Signalmitteln durch eine kontaktfreie Signalübertragung verbunden. Schließlich weist die Bedieneinheit eine Energieversorgung auf. Zur Erhöhung der mechanischen Stabilität sowie Exaktheit einer Bedienung besteht die Bedieneinheit aus der Drehvorrichtung und einer Lagervorrichtung für die Drehvorrichtung. Dabei ist die Drehvorrichtung drehbewegbar an der Lagervorrichtung gelagert. Die Lagervorrichtung wiederum ist im wesentlichen unbeweglich an der Abdeckung fixiert zu befestigen. Dabei kann sie auch wieder abgenommen werden. Die Fixierung dient vor allem dazu, bei der Bedienung der Bedieneinheit die notwendige Genauigkeit einzuhalten sowie ein Bediengefühl ähnlich wie bei einem feststehenden Drehwahlschalter zu erzeugen.

Durch die erfindungsgemäße Lösung kann eine im wesentlichen autarke Bedieneinheit geschaffen werden, die selber die Signalmittel aufweist. Dadurch kann auf separate Signalmittel am Elektrogerät selber verzichtet werden. Durch die Anordnung der Signalmittel direkt in der Bedieneinheit kann eine jederzeit korrekte Zuordnung vorgegeben werden. Die Signale, die die Bedieneinheit an die Steuerung der Bedienvorrichtung bzw. das Elektrogerät sendet, können aus ursprünglichen Stellungs-und/oder Stellungsänderungssignalen erzeugt werden derart, dass sie direkt zur Ansteuerung von Funktionseinheiten des Elektrogeräts verwendet werden können.

Die Signalmittel können unterschiedlich arbeiten. Bevorzugt sind sie für eine magnetische Arbeitsweise ausgebildet, wobei sie mindestens einen Signalmagnet sowie mindestens einen Magnetfeldsensor aufweisen. Besonders bevorzugt sind mehrere Signalmagnete und/oder mehrere Magnetfeldsensoren vorhanden. Dadurch kann eine umso genauere Erfassung von Stellungsänderungen bzw. einer Drehbedienung erfolgen.

Bei einer alternativen Ausführungsmöglichkeit der Erfindung können die Signalmittel derart ausgebildet sein, dass sie in verschiedenen Stellungen unterschiedliche, insbesondere unterschiedlich große, elektrische Signale erzeugen. Dies ist beispielsweise durch ein Potentiometer oder einen sogenannten Grey-Code-Schalter möglich. Während bei den vorgenannten Verfahren mit Magnetfeldsensoren im wesentlichen Pulse entsprechend vorbestimmten Winkelschritten erzeugt werden, wird hier das elektrische Signal in seiner Größe verändert.

Die Lagervorrichtung kann dabei an der Abdeckung mittels einer Haltekraft befestigbar sein. Die Haltekraft kann von Haltemitteln unterschiedlich erzeugt werden, beispielsweise magnetisch. Dies ermöglicht es, die Fixierung vorzunehmen ohne dass sie sichtbar ist.

Die Lagervorrichtung kann in die Bedieneinheit integriert sein. Des weiteren kann die Bedieneinheit die Steuerung aufweisen. Weiters ist es möglich, auch die vorgenannte Energieversorgung an der Bedieneinheit vorzusehen. Hier ist es vorteilhaft, dass die Lagervorrichtung gegenüber dem Elektrogerät stellungsunveränderlich vorgesehen werden kann. Somit kann sie beispielsweise als Referenzpunkt für eine Drehbedienung der Bedieneinheit dienen. Auch für die Energieversorgung ist es von Vorteil, wenn sie an einer bestimmten Position erfolgt.

Der vorgenannte Signalmagnet kann vorteilhaft an der Drehvorrichtung befestigt sein, während der wenigstens eine Magnetfeldsensor an der übrigen Bedieneinheit, insbesondere lagefest, angeordnet werden kann. Besonders bevorzugt wird dann der Magnetfeldsensor an der Lagervorrichtung angeordnet. Dies weist den Vorteil auf, dass hier auch die Steuerung angeordnet werden kann und somit die Verbindung der beiden zueinander einfach ist.

Die Steuerung selber kann eine Signalverarbeitung aufweisen, insbesondere für die Signale der Magnetfeldsensoren. Hier kann ein Mikrokontroller vorgesehen sein. Damit ist es möglich, Signale der Signalmittel in Schaltsignale zur Bedienung des Elektrogeräts umzuwandeln. Damit gibt die Bedieneinheit nicht lediglich Signale ab, welche eine Drehbetätigung in irgendeiner Form charakterisieren. Vielmehr ist es möglich, direkt Signale zur erzeugen, die beispielsweise zur Ansteuerung elektronischer Leistungsschalter verwendet werden können.

Bevorzugt ist die Bedieneinheit zur Bedienung eines Teils, insbesondere einer einzigen Funktionseinheit des Elektrogeräts wie beispielsweise einer Strahlungsheizung entsprechend einer Kochplatte, ausgebildet. Damit kann eine Bedieneinheit entsprechend einem üblichen Drehknebel mit elektrischem Schalter, wie sie beispielsweise bei Kochfeldern üblich sind, ausgebildet werden.

Die Energieversorgung der Bedieneinheit kann einerseits durch eine eigene Energiequelle wie beispielsweise eine Batterie oder einen aufladbaren Akkumulator erfolgen. Bevorzugt ist jedoch eine Energieübertragung von dem Elektrogerät an die Bedieneinheit vorgesehen. Diese kann besonders bevorzugt kontaktfrei erfolgen, beispielsweise transformatorisch und durch Wandungen des Elektrogeräts sowie der Bedieneinheit hindurch. Zur transformatorischen Energieübertragung können jeweils Spulen am Elektrogerät sowie in der Bedieneinheit, bevorzugt an der Lagervorrichtung, vorgesehen sein. Eine transformatorische Energieübertragung weist den großen Vorteil auf, dass hierbei auf elektrische Zuleitungen oder elektrische Kontakte, welche beispielsweise im Betrieb eines Elektrogerätes leicht verschmutzen können, verzichtet werden kann. Dies erhöht Betriebssicherheit sowie Betriebskomfort.

Des weiteren ist es möglich, die Energieübertragung zur Signalübertragung, insbesondere von der Bedieneinheit bzw. der Steuerung der Bedieneinheit zu der restlichen Bedienvorrichtung, auszubilden. Dies kann durch Takten entsprechend der Information erreicht werden. Insbesondere ist es möglich, durch eine Taktung bzw. eine nach Art von Zeitfenstern versetzte Übertragung von Energie oder Signalen beide Betriebsarten durch dieselbe Vorrichtung zu übernehmen.

In weiterer Ausgestaltung der Erfindung kann die Signalübertragung bidirektional ausgebildet sein. Dies ermöglicht es beispielsweise, nicht nur Steuersignale von der Steuerung der Bedieneinheit an die Bedienvorrichtung und somit an das Elektrogerät weiterzugeben. Ebenso kann eine Rückmeldung an die Bedieneinheit erfolgen, beispielsweise um einen Regelkreis zu schließen. Weiters kann es gemäß der Erfindung vorgesehen sein, an der Bedieneinheit elektrische Anzeigemittel vorzusehen, welche mit der Energieversorgung und der Steuerung verbunden sind. Diese können zur Darstellung von Zeichen oder Symbolen ausgebildet sein. Vor allem hier ist eine Signalübertragung von dem Elektrogerät über die Bedienvorrichtung an die Anzeigemittel der Bedieneinheit von Vorteil. Dadurch kann an einer Anzeige der Bedieneinheit der tatsächliche Zustand des Elektrogeräts angezeigt werden.

Die Anzeigemittel sind bevorzugt an der Lagervorrichtung angeordnet. Dies ermöglicht eine einfache und direkte Befestigung, insbesondere auch eine direkte Verbindung zu Steuerung und/oder Energieversorgung an der Lagervorrichtung. Vor allem ist es möglich, sie an der Lagervorrichtung auch bei Drehbetätigung der Drehvorrichtung positionsfest anzuordnen. Beispielsweise ist es möglich, die Anzeigemittel zentral über der Drehachse der Drehvorrichtung anzuordnen. Dabei steht die Drehachse in diesem Fall im wesentlichen senkrecht von dem Bereich ab, auf den die Bedieneinheit auf das Elektrogerät aufgesetzt ist. Weiters ist eine Anzeige vorteilhaft an einer Oberseite der Bedieneinheit angeordnet.

Für die Anzeige selber können Leuchtmittel vorgesehen sein, beispielsweise LED, welche sich durch geringen Stromverbrauch auszeichnen. Besonders bevorzugt können zwei gegenseitig parallel geschaltete LED vorgesehen sein, welche mit der Energieversorgung in der Bedieneinheit verbunden sind. Dies weist den Vorteil auf, dass beispielsweise eine transformatorische Energieübertragung eine Wechselspannung erzeugt wird und diese mit gegensinnig geschalteten LED vollständig genutzt werden kann.

Bei einer weiteren Ausgestaltung der Erfindung ist die Bedieneinheit zur Bedienung anderer Funktionseinheiten desselben Elektrogeräts oder eventuell anderer Elektrogeräte, auch anderen Typs, ausgebildet. Dies ermöglicht es beispielsweise, eine Bedieneinheit sowohl für ein Kochfeld als auch für einen Backofen oder eine Waschmaschine zu benutzen. Eine solche Bedieneinheit kann an dem jeweiligen Elektrogerät angebracht werden und beispielsweise selbsttätig auf bekannte Art und Weise die Kommunikation mit dem Elektrogerät aufnehmen, um dann dessen Steuerung bzw. Beeinflussung zu übernehmen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ein Ausführungsbeispiel der Erfindung ist in den Zeichnungen dargestellt und wird im folgenden näher erläutert. In den Zeichnungen zeigen:
- Fig. 1: einen schematischen Schnitt durch eine erfindungsgemäße Bedieneinheit,
- Fig. 2: eine schematische Darstellung von Signalmitteln, die durch fünf verteilte Signalmagnete und zwei Hall-Sensoren gebildet werden und
- Fig. 3: eine möglichst einfache Ausbildung einer von zwei LED gebildeten Leuchtanzeige.

### Detaillierte Beschreibung des Ausführungsbeispiels

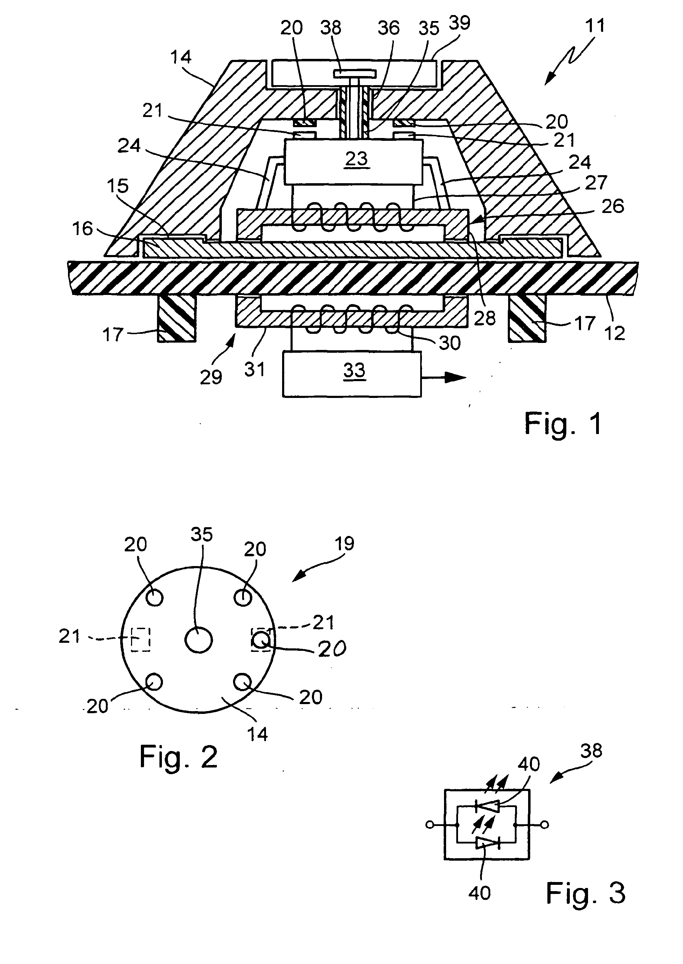

In Fig. 1 ist eine Bedieneinheit 11 im Schnitt dargestellt, wie sie bei einer Ausführungsmöglichkeit der Erfindung geschaffen werden kann. Hierbei ist zu beachten, dass Fig. 1, ebenso wie Fig. 2 und Fig. 3, schematisch zu verstehen ist, um die Funktionalität einer erfindungsgemäßen Bedieneinheit auch in ihren Details darzustellen.

Die Bedieneinheit 11 ist auf ein Glaskeramikfeld 12 aufgesetzt. Dieses ist Bestandteil eines Glaskeramikkochfeldes. Es könnte jedoch eine beliebige Abdeckung, auch aus Kunststoff oder als Blende eines Elektrogerätes, vorhanden sein.

Die Bedieneinheit 11 besteht aus einem Drehknebel 14 und ist zur Drehbetätigung des Elektrogerätes bzw. einer an dem Elektrogerät vorhandenen, nicht dargestellten Funktionseinheit ausgebildet. Eine solche Funktionseinheit kann beispielsweise eine Kochstelle eines Kochfeldes sein. Der Drehknebel 14 läuft dabei nach oben hin konisch zu. Dies ist jedoch nicht zwangsläufig. Wichtig ist nur, dass der Drehknebel 14 eine Art Gehäuse für die in ihm untergebrachten Teile bzw. Funktionseinheiten bildet, welche im folgenden weiter erläutert werden.

Gelagert ist der Drehknebel 14 auf einer Lagervorrichtung 15, wobei die Lagerung eine Drehlagerung ist. Die Lagervorrichtung 15 ist im wesentlichen positionsfest an dem Glaskeramikfeld 12 befestigbar. Diese Befestigung kann, wie dargestellt, vorteilhaft lösbar sein. Hierbei ist es möglich, die äußeren Enden 16 der Lagervorrichtung 15 magnetisch oder magnetisch wirksam auszubilden. Entsprechende Haltemagnete 17, die unter dem Glaskeramikfeld 12 angeordnet sind, halten die aufgesetzte Lagervorrichtung 15 bzw. Bedieneinheit 11 fest. Diese Art der Befestigung sollte einerseits so fest sein, dass bei einer normalen Drehbetätigung des Drehknebels 14 bzw. der Bedieneinheit 11 die Position nicht geändert wird. Andererseits sollte die Bedieneinheit 11 ohne allzu großen Kraftaufwand von dem Glaskeramikfeld 12 gelöst werden können, beispielsweise zu Reinigungszwecken, zur Sicherheit oder zum Einsatz an anderer Stelle.

Die Bedieneinheit 11 weist Signalmittel 19 auf, mittels derer die Position oder eine Positionsänderung zwischen orts- und positionsfester Lagervorrichtung 15 sowie daran drehbar gelagertem Drehknebel 14 möglich ist. Dazu weisen die Signalmittel 19 Signalmagnete 20 auf, die an der oberen Innenseite des Drehknebels 14 angeordnet sind. An der Lagervorrichtung 15 bzw. auf einer Steuerung 23, die positionsfest mit der Lagervorrichtung 15 verbunden ist, sind entsprechende Hall-Sensoren 21 vorgesehen. Die Anordnung kann im Detail aus der Draufsicht in Fig. 2 entnommen werden. Hier sind beispielhaft fünf gleichmäßig verteilte Signalmagnete 20 und zwei Hall-Sensoren 21 vorgesehen. Bei einer Drehung von Drehknebel 14 gegenüber der Lagervorrichtung 15 wandern die einzelnen Signalmagnete 20 über die Hall-Sensoren 21 und erzeugen an diesen abwechselnd Signale. Daraus kann eine Drehung charakterisiert werden. Zur Erhöhung der Genauigkeit der Feststellung einer Drehung können noch mehr Signalmagnete oder Hall-Sensoren vorgesehen werden.

Wie zuvor angesprochen, ist eine Steuerung 23 in einem entsprechenden Gehäuse mittels Stützen 24 fest an der Lagervorrichtung 15 angeordnet. Die Steuerung weist vorteilhaft einen Mikrokontroller auf, der die Signale der Signalmittel 19 bzw. der Hall-Sensoren 21 auswertet. Bei dieser Auswertung gibt die Steuerung 23 vorteilhaft nicht nur die reinen Stellsignale der Hall-Sensoren 21 weiter, sondern ermittelt daraus Signale, wie sie beispielsweise direkt zur Ansteuerung von Leistungsschaltern, seien es elektromechanische Relais oder elektronische, verwendet werden. Somit kann vorgesehen sein, einen Teil, insbesondere die ganze, Intelligenz einer Steuerung in der Steuerung 23 der Bedieneinheit zu vereinigen.

Mittels der Stützen 24 ist die Steuerung 23 an einem ersten Übertrager 26, nämlich an dem oberen Joch 28, der Lagervorrichtung 15 befestigt.

Selbstverständlich kann eine Befestigung auch direkt an der Lagervorrichtung 15 erfolgen, hier sind keine Grenzen gesetzt.

Der erste Übertrager 26 besteht dabei aus einer oberen Spule 27, die mit der Steuerung 23 verbunden ist und um das obere Joch 28 geführt ist. Ein dazu korrespondierender zweiter Übertrager 29 ist unterhalb des Glaskeramikfeldes 12 angeordnet. Er besteht ebenfalls aus einer unteren Spule 30 sowie einem unteren Joch 31. Der zweite Übertrager 29 ist ähnlich wie die Haltemagnete 15 ortsfest an der Unterseite des Glaskeramikfeldes 12 befestigt. Dies kann beispielsweise durch Ankleben oder eine stabile Halterung unterhalb des Glaskeramikfeldes 12 erfolgen.

Mit der unteren Spule 30 ist eine untere Steuerung 33 verbunden. Diese kann jedoch in Ergänzung zu dem vorher Gesagten beispielsweise nur einen Teil, insbesondere gar keine, Intelligenz der Steuerung beinhalten. Die wesentliche Aufgabe der unteren Steuerung 33 besteht darin, die Signalübertragung zwischen dem ersten Übertrager 26 und dem zweiten Übertrager 29 zu der Steuerung 23 hin sicherzustellen. Im einfachsten Fall sind also Signalleitungen lediglich durch die untere Steuerung 33 hindurchgeführt an beispielsweise Leistungsschalter des Elektrogeräts.

In weiterer Ausgestaltung der Erfindung ist es jedoch möglich, wie eingangs erwähnt, die Signalübertragung nicht nur von der Steuerung 23 an Leistungsschalter zu führen. Ebenso ist es möglich, Rückmeldungen bzw. eine Signalübertragung von dem Elektrogerät an die Steuerung 23 vorzusehen. Es kann beispielsweise eine geschlossene Regelschleife gebildet werden, die durch die Steuerung 23 überwacht und beeinflusst wird. Hierfür kann in der unteren Steuerung 33 in Zusammenwirkung mit der oberen Steuerung 23 beispielsweise eine zeitfenstergesteuerte Übertragung jeweils in eine Richtung aufgebaut werden.

Zur Lagerung des Drehknebels 14 an der Lagervorrichtung 15 sind einmal, wie aus der Fig. 1 zu erkennen ist, die Enden 16 der Lagervorrichtung vorgesehen. Diese greifen in entsprechende Ausnehmungen des Drehknebels 15 ein und stellen eine gewisse radiale Führung sicher. Zusätzlich ist an der Oberseite des Gehäuses der Steuerung 23 eine Drehachse 35 vorgesehen, die somit ortsfest ist. An der Drehachse 35 ist mittels eines Drehlagers 36 der Drehknebel 14 gelagert. In einen entsprechenden Ausschnitt der Oberseite des Drehknebels 14 ist eine Abdeckung 39 eingesetzt.

Die Abdeckung 39 kann einerseits den Zweck haben, ein axiales Abziehen des Drehknebels 14 von der Lagervorrichtung zu verhindern. Dies wäre beispielsweise auch durch nach oben hin breiter ausgeführte Enden 16 der Lagervorrichtung 15 möglich. Diese greifen in übergreifende und festklemmende Ausnehmungen in der Unterseite des Drehknebels 14 ein. Eine Befestigung der Abdeckung 39 an der Drehachse 35 kann beispielsweise durch Aufstecken oder, alternativ, durch eine Verschraubung oder Verklebung erfolgen.

Des weiteren weist die Abdeckung 39 eine Leuchtanzeige 38 auf, die mit Anschlussleitungen mit der Steuerung 23 verbunden ist. Diese Leuchtanzeige 38 kann vielfältig ausgeführt sein. Sie kann entweder nur Lichtsignale abstrahlen. In weiterer Ausgestaltung der Erfindung kann sie als Symbolanzeige oder sogar als Sieben-Segmentanzeige ausgebildet sein. Ebenso ist es möglich, sie ortsfest an der Drehachse 35 oder, falls die Abdeckung 39 ortsfest angeordnet ist, auch an dieser zu befestigen.

In weiterer Ausgestaltung der Erfindung kann auf der Oberseite der Steuerung 23 eine Leuchtanzeige angeordnet sein, die durch den dargestellten Kanal in der Drehachse 35 nach oben strahlt. Dann könnte die Abdeckung 39 auch fest mit dem Drehknebel 14 verbunden und somit drehbar sein.

Eine besonders einfache Ausgestaltung einer Leuchtanzeige 38 ist in Fig. 3 dargestellt. Sie besteht aus zwei gegensinnig verschalteten LED 40. Durch diese gegensinnige Verschaltung ist es möglich, sie mit Wechselstrom zu versorgen und eine optimale Energie- bzw. Lichtausbeute zu erzielen. Selbstverständlich sind alle möglichen gebräuchlichen Leuchtanzeigen für Bedienelemente oder dergleichen verwendbar.

Zur Versorgung der Leuchtanzeige 38 sowie der Steuerung 23 wird eine Energieversorgung benötigt. Diese kann zwar einerseits als Batterie oder Akkumulator in der Steuerung 23 bzw. in der Bedieneinheit 11 vorgesehen sein. Gemäß einer besonders bevorzugten Ausführungsmöglichkeit der Erfindung erfolgt jedoch eine Energieübertragung transformatorisch über die Übertrager 26 und 29. In der Steuerung 23 kann beispielsweise eine kleine Gleichrichterschaltung vorgesehen sein, um eine Versorgung der Steuerung in benötigter Weise sicherzustellen.

Vorteilhaft erfolgen Signalübertragung und Energieübertragung in getrennten Zeitfenstern, beispielsweise getaktet. Ebenso ist es möglich, in der Steuerung 23 einen Energiespeicher in Form eines Kondensators entsprechender Kapazität oder eines Akkumulators vorzusehen. Dieser kann in Zeitabschnitten, in denen momentan keine Signalübertragung stattfindet oder sich das Elektrogerät in einem Standby-Modus befindet, erfolgen.

Eine Aufteilung der Signalübertragung und Energieübertragung in zeitliche Abschnitten kann entweder von der oberen Steuerung 23 oder der unteren Steuerung 33 übernommen werden. An sich jedoch ist eine solche aufgeteilte Übertragung bekannt und für den Fachmann ohne größere Probleme ausführbar.

Somit kann gemäß der dargestellten Ausführungsmöglichkeit der Erfindung eine Bedieneinheit 11 geschaffen werden, die einerseits einen Drehknebel 14 zur Drehbetätigung eines Elektrogeräts aufweist. Dabei ist die Bedieneinheit 11 auf einer Abdeckung, beispielsweise dem Glaskeramikfeld 12, eines Elektrogerätes, in diesem Fall eines Kochfeldes, befestigbar. Die Lagerung erfolgt ortsfest mittels der magnetisch gehalterten Lagervorrichtung 15.

Der Vorteil einer solchen Lagervorrichtung besteht darin, dass sie von der Abdeckung abgenommen werden kann und keinerlei sichtbare bzw. mechanische Haltemittel vorgesehen sind. Andererseits kann der Drehknebel wie bei üblichen Drehknebeln mit der Drehachse 35 und dem Drehlager 36 sehr genau gelagert werden, was bei der Erzeugung der Positionssignale von großem Vorteil ist.

In der Bedieneinheit 11 ist die gesamte Intelligenz einer Steuerung für die zugeordnete Funktionseinheit vorhanden. Da Signalübertragung und Energieübertragung transformatisch bzw. über die Übertrager 26 und 29 erfolgen, sind keinerlei offenen elektrischen Anschlüsse, Verbindungsstecker oder Kabel nötig.

Die Bedieneinheit 11 kann am Drehknebel 14 mit Anzeigemitteln, beispielsweise einfachen Leuchtmitteln oder einer Sieben-Segmentanzeige, ausgestattet sein. So kann die Bedieneinheit 11 Informationen bzw. Rückmeldungen anzeigen.

Der große Vorteil, die Signalmittel 19 ausschließlich an der Bedieneinheit 11 vorzusehen, liegt darin, dass sie derart ausgebildet sein können, dass eine Detektierung von Positionsveränderungen sehr genau möglich ist. Dabei kann der Aufbau relativ einfach gehalten sein.

## Patentansprüche

1. Bedienvorrichtung für ein Elektrogerät, vorzugsweise ein Elektrowärmegerät, wobei
- die Bedienvorrichtung eine Bedieneinheit mit einer Vorrichtung (14) zur Bedienung des Elektrogeräts aufweist,
- die Bedieneinheit (11) auf einer Abdeckung (12) des Elektrogerätes befestigbar ist,
- Signalmittel (19) vorgesehen sind zur Erzeugung von Signalen abhängig von einer Stellung und/oder Stellungsänderung der Vorrichtung (14),
- ausschließlich die Bedieneinheit (11) Signalmittel (19) aufweist,
- die Bedieneinheit (11) eine Steuerung (23) zur Verarbeitung der Signale zur Beeinflussung des Elektrogeräts aufweist,
- die Steuerung mit den Signalmitteln (19) verbunden ist,
- die Bedieneinheit (11) eine Energieversorgung (26, 29) aufweist,
- die Bedienvorrichtung eine Signalübertragung (26, 29) von den Signalmitteln (19) an das Elektrogerät aufweist und
- die Signalübertragung (26, 29) kontaktfrei ist
- **dadurch gekennzeichnet, dass** die Vorrichtung eine Drehvorrichtung zur Drehbedienung ist und dass die Bedieneinheit (11) aus der Drehvorrichtung (14) und einer Lagervorrichtung (15) für die Drehvorrichtung (14) besteht, wobei die Drehvorrichtung drehbewegbar an der Lagervorrichtung gelagert ist und die Lagervorrichtung (15) im wesentlichen unbeweglich an der Abdeckung (12) fixiert befestigbar und abnehmbar ist.

2. Bedienvorrichtung nach Anspruch 1, **dadurch gekennzeichnet, dass** die Signalmittel (19) für eine magnetische Arbeitsweise ausgebildet sind und mindestens einen Signalmagnet (20) sowie mindestens einen Magnetfeldsensor (21) aufweisen, wobei vorzugsweise mehrere Signalmagnete und/oder Magnetfeldsensoren vorhanden sind.

3. Bedienvorrichtung nach Anspruch 1, **dadurch gekennzeichnet, dass** die Signalmittel (19) bei verschiedenen Stellungen unterschiedliche, insbesondere unterschiedlich große, elektrische Signale erzeugt, wobei vorzugsweise die Signalmittel ein Potentiometer aufweisen.

4. Bedienvorrichtung nach einem der vorhergehenden Ansprüche, **dadurch gekennzeichnet, dass** die Lagervorrichtung (15) an der Abdeckung (12) mittels einer Haltekraft befestigbar ist, wobei die Haltekraft von magnetischen Haltemitteln (16, 17) erzeugt ist.

5. Bedienvorrichtung nach Anspruch 1 oder 4, **dadurch gekennzeichnet, dass** die Steuerung (23) an der Lagervorrichtung (15) angeordnet ist, wobei vorzugsweise auch die Energieversorgung (26) an der Lagervorrichtung angeordnet ist.

6. Bedienvorrichtung nach Anspruch 2, **dadurch gekennzeichnet, dass** der wenigstens eine Signalmagnet (20) an der Drehvorrichtung (14) und der wenigstens eine Magnetfeldsensor (21) an der übrigen Bedieneinheit (11), insbesondere an der Lagervorrichtung (15), angeordnet ist.

7. Bedienvorrichtung nach einem der vorhergehenden Ansprüche, **dadurch gekennzeichnet, dass** die Steuerung (23) eine Signalverarbeitung aufweist, vorzugsweise einen Mikrocontroller, um Signale der Signalmittel (19) in Schaltsignale zur Bedienung des Elektrogerätes umzuwandeln.

8. Bedienvorrichtung nach einem der vorhergehenden Ansprüche, **dadurch gekennzeichnet, dass** die Bedieneinheit (11) zur Bedienung einer einzigen Funktionseinheit des Elektrogerätes ausgebildet ist, wobei vorzugsweise das Elektrogerät ein Kochfeld ist und die Funktionseinheit eine Heizeinrichtung ist.

9. Bedienvorrichtung nach einem der vorhergehenden Ansprüche, **dadurch gekennzeichnet, dass** die Energieversorgung (26, 29) mittels Energieübertragung von dem Elektrogerät an die Bedieneinheit (11) erfolgt, wobei vorzugsweise die Energieversorgung kontaktfrei durch die Abdeckung (12) hindurch und insbesondere transformatorisch erfolgt.

10. Bedienvorrichtung nach Anspruch 9, **dadurch gekennzeichnet, dass** die Energieübertragung (26, 29) zur Signalübertragung von der Bedieneinheit (11) zu der restlichen Bedienvorrichtung (33) bzw. zum Elektrogerät ausgebildet ist, vorzugsweise durch Taktung bzw. zeitversetzte Übertragung von Energie oder Signalen, wobei insbesondere die Signalübertragung (26, 29) bidirektional ausgebildet ist.

11. Bedienvorrichtung nach einem der vorhergehenden Ansprüche, **dadurch gekennzeichnet, dass** der Bedieneinheit (11) elektrische Anzeigemittel (38, 40) zugeordnet und mit der Energieversorgung (26, 29) und der Steuerung (23) verbunden sind, wobei vorzugsweise die Anzeigemittel zur Darstellung von Zeichen oder Symbolen ausgebildet sind.

12. Bedienvorrichtung nach Anspruch 11, **dadurch gekennzeichnet, dass** die Anzeigemittel (38, 40) an der Lagervorrichtung (15) angeordnet sind und bei Drehbetätigung der Drehvorrichtung (14) positionsfest sind.

## Claims

1. A control apparatus for an electric appliance, preferably an electric heating appliance,
- the control apparatus comprising a control unit with an apparatus (14) for controlling the electric appliance,
- the control unit (11) being fastenable to a cover (12) of the electric appliance,
- signaling means (19) being provided for generating signals as a function of a position and/or position change of the apparatus (14),
- solely the control unit (11) comprising signaling means (19),
- the control unit (11) comprising a controller (23) for processing the signals for influencing the electric appliance,
- the controller being connected with the signaling means (19),
- the control unit (11) comprising a power supply (26, 29),
- the control apparatus comprising signal transmission (26, 29) from the signaling means (19) to the electric appliance and
- signal transmission (26, 29) being contactless
- wherein the apparatus is a rotary apparatus for rotary operation and wherein the control unit (11) consists of the rotary apparatus (14) and a bearing apparatus (15) for the rotary apparatus (14), the rotary apparatus being mounted rotatably movably on the bearing apparatus and the bearing apparatus (15) being fastenable so as to be fixed substantially immovably to the cover (12) and so as to be removable.

2. The control apparatus as claimed in claim 1, wherein the signaling means (19) are constructed for a magnetic mode of operation and comprise at least one signal magnet (20) and at least one magnetic field sensor (21), a plurality of signal magnets and/or magnetic field sensors preferably being provided.

3. The control apparatus as claimed in claim 1, wherein the signaling means (19) generate different electrical signals, in particular electrical signals of different magnitudes, at different positions, the signaling means preferably comprising a potentiometer.

4. The control apparatus as claimed in any one of the preceding claims, wherein the bearing apparatus (15) may be fastened to the cover (12) by means of a holding force, the holding force being produced by magnetic holding means (16, 17).

5. The control apparatus as claimed in claim 1 or 4, wherein the controller (23) is arranged on the bearing apparatus (15), the power supply (26) preferably also being arranged on the bearing apparatus.

6. The control apparatus as claimed in claim 2, wherein the at least one signal magnet (20) is arranged on the rotary apparatus (14) and the at least one magnetic field sensor (21) is arranged on the remaining control unit (11), in particular on the bearing apparatus (15).

7. The control apparatus as claimed in any one of the preceding claims, wherein the controller (23) comprises a signal processing means, preferably a microcontroller, for converting signals from the signaling means (19) into switching signals for controlling the electric appliance.

8. The control apparatus as claimed in any one of the preceding claims, wherein the control unit (11) is designed to control a single functional unit of the electric appliance, the electric appliance preferably being a hob and the functional unit being a heating device.

9. The control apparatus as claimed in any one of the preceding claims, wherein the power supply (26, 29) operates by transmitting power from the electric appliance to the control unit (11), the power preferably being supplied contactlessly through the cover (12) and in particular inductively.

10. The control apparatus as claimed in claim 9, wherein the power transmission (26, 29) is designed for signal transmission from the control unit (11) to the remaining control apparatus (33) or to the electric appliance, preferably in cycles or by time-delayed transmission of power or signals, the signal transmission (26, 29) being in particular bidirectional.

11. The control apparatus as claimed in any one of the preceding claims, wherein electrical display means (38, 40) are associated with the control unit (11) and are connected to the power supply (26, 29) and the controller (23), the display means preferably being designed to display characters or symbols.

12. The control apparatus as claimed in claim 11, wherein the display means (38, 40) are arranged on the bearing apparatus (15) and are fixed in position during rotary actuation of the rotary apparatus (14).

## Revendications

1. Dispositif de commande pour un appareil électrique, de préférence un appareil électrothermique, où
- le dispositif de commande présente une unité de commande avec un dispositif (14) pour la commande de l'appareil électrique,
- l'unité de commande (11) peut être fixée sur un recouvrement (12) de l'appareil électrique,
- on prévoit des moyens de signalisation (19) pour la génération de signaux en fonction d'une position et/ou d'un changement de position du dispositif (14),
- uniquement l'unité de commande (11) présente des moyens de signalisation (19),
- l'unité de commande (11) présente une commande (23) pour le traitement des signaux afin d'agir sur l'appareil électrique,
- la commande est raccordée aux moyens de signalisation (19),
- l'unité de commande (11) présente une alimentation en énergie (26, 29),
- le dispositif de commande présente une transmission de signaux (26, 29) à partir des moyens de signalisation (19) à l'appareil électrique et où
- la transmission de signaux (26, 29) fonctionne sans contact direct,
- **caractérisé en ce que** le dispositif est un dispositif rotatif pour une commande rotative et **en ce que** l'unité de commande (11) est composée du dispositif rotatif (14) et d'un dispositif de logement (15) pour le dispositif rotatif (14), sachant que le dispositif rotatif est logé auprès du dispositif de logement de manière à permettre des mouvements rotatifs et que le dispositif de logement (15) peut être fixé sur le recouvrement (12) de manière fixe essentiellement immobile en étant toutefois détachable.

2. Dispositif de commande d'après la revendication 1, **caractérisé en ce que** les moyens de signalisation (19) sont réalisés pour un mode de fonctionnement magnétique et qu'ils présentent au moins un aimant de signalisation (20) ainsi qu'au moins un détecteur de champ magnétique (21), sachant qu'on prévoit de préférence plusieurs aimants de signalisation et/ou détecteurs de champ magnétique.

3. Dispositif de commande d'après la revendication 1, **caractérisé en ce que** les moyens de signalisation (19) produisent des signaux électriques différents, notamment des signaux électriques d'ampleur différente selon les différentes positions, sachant que de préférence les moyens de signalisation présentent un potentiomètre.

4. Dispositif de commande d'après une des revendications précédentes, **caractérisé en ce que** le dispositif de logement (15) peut être fixé auprès du recouvrement (12) par une force de retenue, sachant que la force de retenue est produite par des moyens de retenue (16, 17) magnétiques.

5. Dispositif de commande d'après la revendication 1 ou 4, **caractérisé en ce que** la commande (23) est disposée auprès du dispositif de logement (15), sachant que de préférence l'alimentation en énergie (26) est également disposée auprès du dispositif de logement.

6. Dispositif de commande d'après la revendication 2, **caractérisé en ce que** le ou les aimants de signalisation (20) sont disposés auprès du dispositif rotatif (14) et que le ou les détecteurs de champ magnétique (21) sont disposés auprès du reste de l'unité de commande (11), notamment auprès du dispositif de logement (15).

7. Dispositif de commande d'après une des revendications précédentes, **caractérisé en ce que** la commande (23) présente un moyen de traitement de signaux, de préférence un microcontroller, pour transformer des signaux produits par les moyens de signalisation (19) en signaux de commutation pour la commande de l'appareil électrique.

8. Dispositif de commande d'après une des revendications précédentes, **caractérisé en ce que** l'unité de commande (11) est réalisée pour la commande d'une seule unité fonctionnelle de l'appareil électrique, sachant que de préférence l'appareil électrique est une table de cuisson et que l'unité fonctionnelle est un dispositif de chauffe.

9. Dispositif de commande d'après une des revendications précédentes, **caractérisé en ce que** l'alimentation en énergie (26, 29) a lieu par un transport d'énergie de l'appareil électrique à l'unité de commande (11), sachant que de préférence l'alimentation en énergie a lieu sans contact direct en passant à travers le recouvrement (12) et notamment à la manière d'un transformateur.

10. Dispositif de commande d'après la revendication 9, **caractérisé en ce que** le transport d'énergie (26, 29) est réalisé de manière à permettre une transmission de signaux à partir de l'unité de commande (11) au reste du dispositif de commande (33) ou encore à l'appareil électrique, de préférence par une transmission cadencée ou encore décalée d'énergie ou de signaux, sachant que notamment la transmission de signaux (26, 29) est réalisée de manière bidirectionnelle.

11. Dispositif de commande d'après une des revendications précédentes, **caractérisé en ce qu'**on associe à l'unité de commande (11) des moyens d'affichage (38, 40) et que ceux-ci sont branchés à l'alimentation en énergie (26, 29) et à la commande (23), sachant que de préférence les moyens d'affichage sont réalisés de manière à permettre la représentation de signes ou de symboles.

12. Dispositif de commande d'après la revendication 11, **caractérisé en ce que** les moyens d'affichage (38, 40) sont disposés auprès du dispositif de logement (15) et qu'ils restent immobiles pendant un actionnement giratoire du dispositif rotatif (14).
